(19)

Europäisches
Patentamt
European
Patent Office
Office européen
des brevets

(11)     **EP 2 502 347 B1**

(12)                     **EUROPEAN PATENT SPECIFICATION**

(45) Date of publication and mention
of the grant of the patent:
**08.10.2014   Bulletin 2014/41**

(21) Application number: **10779896.9**

(22) Date of filing: **15.11.2010**

(51) Int Cl.:
**H03K 17/96** (2006.01)     **G01L 9/00** (2006.01)

(86) International application number:
**PCT/US2010/056676**

(87) International publication number:
**WO 2011/062860 (26.05.2011 Gazette 2011/21)**

(54) **ACOUSTIC WAVE SWITCH ASSEMBLY AND METHOD OF FORMING SAME**

SCHALTERANORDNUNG, DIE AUF AKUSTISCHEN WELLEN BERUHT UND VERFAHREN ZU
DEREN HERSTELLUNG

ENSEMBLE COMMUTATEUR À ONDE ACOUSTIQUE ET PROCÉDÉ DE RÉALISATION DE CELUI-
CI

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **18.11.2009   US 262415 P**

(43) Date of publication of application:
**26.09.2012   Bulletin 2012/39**

(73) Proprietor: **Texzec, Inc.**
**Hinsdale, IL 60521 (US)**

(72) Inventor: **BREMIGAN, III, Charles F.**
**Glenview, Illinois 60026 (US)**

(74) Representative: **Boult Wade Tennant**
**Verulam Gardens**
**70 Gray's Inn Road**
**London WC1X 8BT (GB)**

(56) References cited:
**US-A- 6 140 740        US-A1- 2002 126 103
US-A1- 2004 246 239    US-B1- 6 271 621**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

## FIELD OF EMBODIMENTS OF THE INVENTION

Embodiments of the present invention generally relate to acoustic wave switches, and, more particularly, to a method of fabricating a resonant cavity of an acoustic wave switch using filled adhesive polymers.

## BACKGROUND

Acoustic wave switches are described and shown, for example, in United States Patent No. 7,106,310, entitled "Acoustic Wave Touch Actuated Switch" US patent application No. US 2002/0126103 A1 entitled "Acoustic Wave Touch Actuated Switch," and United States Patent No. 7,265,746, entitled "Acoustic Wave Touch Detection Circuit and Method." In general, an acoustic wave switch includes a substrate having an acoustic wave/resonant cavity and a transducer that is configured to generate a trapped acoustic wave within the acoustic wave cavity.

Typical methods of creating a resonant cavity in a substrate of an acoustic wave switch involve traditional machining, such as mechanical or chemical removal/addition, or laser ablation. For example, a ring of material may be cut within the substrate, thereby defining a resonant cavity. All material surrounding the resulting resonant cavity may be removed.

After the resonant cavity has been formed, a transducer is attached to an exposed surface of the resonant cavity using traditional bonding techniques. For example, an adhesive is generally applied to an underside of the transducer, which is then positioned on the exposed surface of the resonant cavity and clamped or otherwise held in place during a bonding process.

The conventional methods of creating an acoustic wave switch assembly may prove, however, costly and time-consuming, while also requiring specialized tooling,

## SUMMARY OF EMBODIMENTS OF THE INVENTION

Certain embodiments of the present invention provide an acoustic wave switch assembly that includes a substrate having first and second surfaces. The first surface is opposite the second surface (such as an upper surface and a lower surface). A filled polymer is positioned on the first surface. A transducer is secured on the filled polymer, wherein a resonant cavity is defined by the filled polymer through the substrate from the first to second surfaces.

The filled polymer may include a base polymer and a filler. The base polymer may include one or more of epoxy, urethane, polyurethane, methacrylate, cyanocrylate, anaerobics, acrylic, phenolics, and/or polyimide. The filler may include a powder including one or more of silver, gold, copper, steel, ceramic, glass, stainless steel, brass, tungsten, titanium, aluminum, magnesium, vanadium, chromium, iron, nickel, zinc, tin and/or other materials with suitable acoustic properties.

Certain embodiments of the present invention provide a method of forming an acoustic wave switch assembly. The method includes depositing or applying an uncured filled polymer on a first surface of a substrate, positioning a transducer on the uncured filled polymer, and curing the uncured filled polymer, wherein the curing secures the filled polymer, the substrate, and the transducer together to form the acoustic wave switch assembly.

The depositing or application defines a resonant cavity from the uncured filled polymer to a second surface of the substrate that is opposite the first surface.

The method may also include forming the uncured filled polymer with a base polymer and filler.

The positioning may include urging the transducer into the uncured filled polymer such that at least a portion of the uncured filled polymer is squeezed out from underneath the transducer and adheres to sides of the transducer.

## BRIEF DESCRIPTION OF SEVERAL VIEWS OF THE DRAWINGS

Figure 1 illustrates an isometric, partial cross-sectional view of an acoustic wave switch, according to an embodiment of the present invention.

Figure 2 illustrates an isometric bottom view of a substrate, according to an embodiment of the present invention.

Figure 3 illustrates a bottom plan view of a substrate, according to an embodiment of the present invention.

Figure 4 illustrates a cross-sectional view of a substrate through line 4- 4 of Figure 3, according to an embodiment of the present invention.

Figure 5 illustrates an isometric bottom view of a substrate having a transducer positioned on a filled polymer that defines a mesa, according to an embodiment of the present invention.

Figure 6 illustrates a flow chart of a method of fabricating a resonant cavity of an acoustic wave switch, according to an embodiment of the present invention.

Before the embodiments of the invention are explained in detail, it is to be understood that the invention is not limited in its application to the details of construction and the arrangement of the components set forth in the following description or illustrated in the drawings. The invention is capable of other embodiments and of being practiced or being carried out in various ways. Also, it is to be understood that the phraseology and terminology used herein are for the purpose of description and should not be regarded as limiting. The use of "including" and "comprising" and variations thereof is meant to encompass the items listed thereafter and equivalents thereof as well as additional items and equivalents thereof.

## DETAILED DESCRIPTION OF EMBODIMENTS OF THE INVENTION

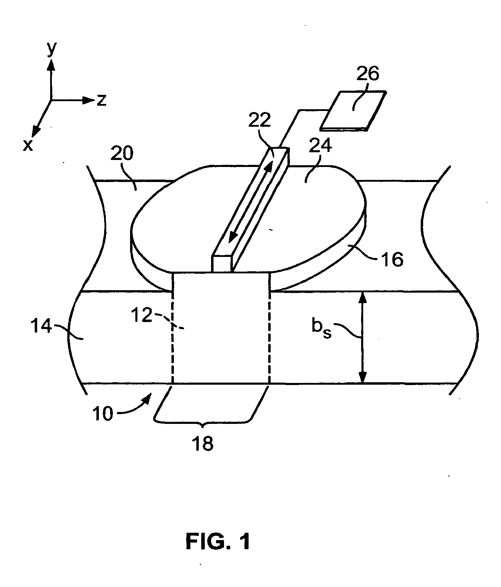

Figure 1 illustrates an isometric, partial cross-sectional view of an acoustic wave switch 10, according to an embodiment of the present invention. The acoustic wave switch 10 includes an associated acoustic wave/resonant cavity 12 that extends through the thickness $b_s$ of a substrate 14. The substrate 14 may be formed of metal, plastic, glass, ceramic, or the like that is capable of supporting a resonant acoustic wave.

The resonant cavity 12 is formed in the substrate 14 such that the mass per unit surface area of the resonant cavity 12 is greater than the mass per unit surface area of the substrate 14 adjacent the resonant cavity 12. In one embodiment, the mass per unit area of the substrate 14 in the switch region is increased to form the resonant cavity 12 by forming a thin plateau or mesa 16 on a surface of the substrate 14 that is parallel to the plane of the substrate 14 and/or a touch surface 18, which is configured to be engaged by an operator. The mesa 16 may be formed on a back surface 20 of the substrate 14 opposite the touch surface 18 of the resonant cavity 12. Alternatively, the mesa 16 may be formed on the touch surface 18.

A transducer 22, such as a piezoelectric transducer, is mounted on a surface 24 of the resonant cavity 12 to generate an acoustic wave that is substantially trapped or localized within the resonant cavity 12. Although the transducer 22 is shown as being mounted on the mesa 16, if the mesa 16 is formed on the touch surface 18 of the substrate 14, the transducer 22 may be mounted directly on the substrate surface of the resonant cavity 12 opposite the mesa 16. The transducer 22 is electrically connected to a sensing circuit 26 or separate processing unit.

The acoustic wave switch 10 may use any type of acoustic wave capable of being substantially trapped in the resonant cavity 12. For simplicity, the acoustic wave switch 10 is described using a shear wave in a direction that is in the plane of the substrate 14, wherein the shear wave energy extends in a direction perpendicular to the plane of the substrate 14, that is, through the thickness of the substrate 14. A shear wave is advantageous because it is insensitive to liquids and other contaminants on the touch surface 18 of the acoustic wave switch 10.

Because the fundamental or zeroth order mode of a horizontally polarized shear wave may not be substantially trapped, higher order shear wave modes are used in accordance with embodiments of the present invention. It should be appreciated that because the acoustic wave used is trapped, the wave is a standing wave.

A standing wave has a number of advantages over an acoustic wave that propagates or travels along a path in a substrate. For example, propagating waves are not confined to the main path of propagation but can diffract off of the main path complicating touch detection. This is opposed to a standing wave which by its nature is confined to the area of a particular resonant cavity 12. Because the acoustic wave is confined, touch detection is easily accomplished. Further, the wave energy of a propagating wave is not stored at any location along the path. Once a propagating wave passes a point along the path, the wave is gone, thereby making timing and control critical for touch detection with propagating waves. There are no timing or control issues with a standing wave because the wave energy is stored in the resonant cavity 12. Moreover, a propagating wave is not a resonating wave. As such, the wave energy decays as it travels. A standing wave is resonant so that the wave is reinforced and prolonged. As a result, the standing wave has a much greater amplitude than a wave that is not confined. The operation of the acoustic wave switch 10 is further described in United States Patent No. 7,106,310, entitled "Acoustic Wave Touch Actuated Switch" (the "'310 patent").

The acoustic wave switch 10 provides a system and method of detecting pressure and movement with respect to the touch surface 18 of the acoustic wave switch 10, using acoustic wave energy that employs trapped energy concepts to create a localized mechanical resonator, or resonant cavity. The '310 patent discloses an acoustic wave switch that includes a substrate with an acoustic wave/resonant cavity formed therein such that the mass per unit area of the acoustic cavity is greater than the mass per unit area of the substrate adjacent the acoustic cavity. A transducer is mounted on the acoustic cavity for generating an acoustic wave that is substantially trapped in the cavity. A touch on the touch surface of the acoustic wave cavity absorbs acoustic wave energy and produces a detectable change in the impedance of the transducer. Moreover, as a user touches the touch surface, the resonant frequency changes, which may be detected by the sensing circuit 26 and/or processing unit which is electrically connected to the transducer.

The acoustic wave switch 10 has a high Q (the ratio, of the stored energy to lost or dissipated energy over a complete cycle) so as to enable a touch to be detected by extremely simple, low-cost circuitry. The acoustic wave switch 10 is rugged, explosion proof, operates in the presence of liquids and other contaminants, and has a low power consumption.

The acoustic wave switch 10 may be connected to an extremely simple touch detection or sensing circuit, such as shown and described in the '310 patent. For example, the transducer 22 may be coupled to a multiplexer that sequentially couples the transducer 22 and its associated acoustic wave switch 10 to an oscillator, as discussed in the '310 patent. Embodiments of the present invention may detect a touch on the touch surface 18 through a detected change in impedance, as described in the '310 patent. A change in impedance is detected as soon as contact is made with the touch surface 18.

Embodiments of the present invention may detect a touch on the touch surface 18 by measuring the decay time of the acoustic wave within the resonant cavity 12. United States Patent No. 7,265, entitled "Acoustic Wave Touch Detection Circuit and Method" (the "'746 patent"), describes a controller that detects a sensed event such as a touch on an acoustic wave switch/sensor based on the decay time. The trapped acoustic wave within the acoustic wave/resonant cavity acts to "ring" the acoustic wave/resonant cavity. That is, as a voltage is applied to the transducer, the transducer operates to resonate the resonant cavity.

As described in the '746 patent, the sensing circuit 26 operatively connected to the acoustic wave switch 10 may include a controller that drives the transducer 22 to generate a resonant acoustic wave in the resonant cavity 12 during a first portion of a sampling cycle. In a second portion of the sampling cycle, the controller monitors the time that it takes for the acoustic wave signal from the transducer 22 to decay to a predetermined level. Based on the decay time, the controller detects a sensed event, such as a touch on the touch surface 18.

Embodiments of the present invention provide a method of efficiently forming an acoustic wave switch, such as the acoustic wave switch 10. As discussed *infra,* embodiments of the present invention provide a method of fabricating the resonant cavity 12 using a filled polymer with adhesive properties.

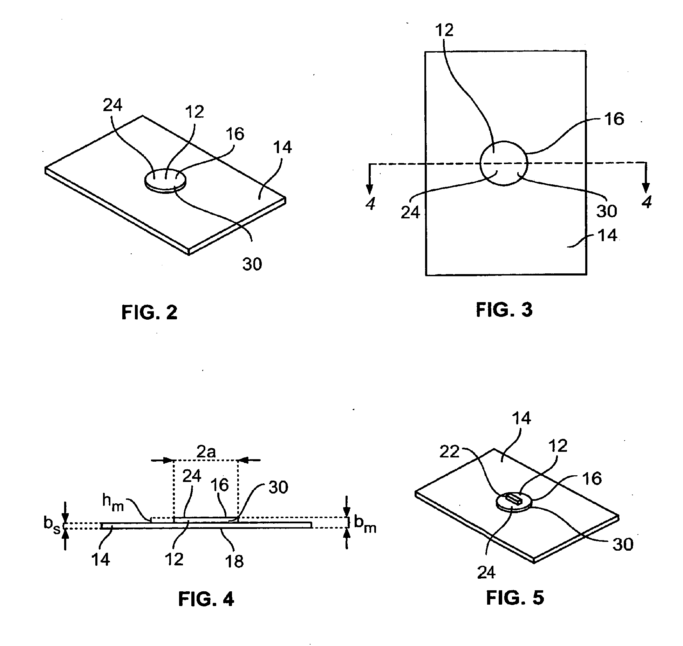

Figures 2 and 3 illustrate isometric bottom and bottom plan views, respectively, of the substrate 14, according to an embodiment of the present invention. In order to form the mesa 16, a filled polymer 30, such as an adhesive base polymer and filler, is deposited or otherwise applied on the substrate 14. The mesa 16 is formed from the filled polymer 30. The filled polymer 30 may be an epoxy resin-based adhesive/polymer filled with material, such as metal particles, that increases the density of the adhesive/polymer. The density of the filled polymer 30 that defines the mesa 16 may match that of the substrate 14.

As shown in Figures 2 and 3, the filled polymer 30 may have a circular axial cross-section. Optionally, the filled polymer may be deposited on the substrate 14 in a variety of other cross-sections, such as, for example, square, rectangular or annular ring cross-sections.

As noted above, the filled polymer 30 has adhesive qualities. The filled polymer 30 includes a base polymer to which a powder material is added as filler in order to achieve the physical properties that are advantageous in forming the resonant cavity 12 of the substrate 14. The base polymer may include one or more of epoxy, urethane, polyurethane, methacrylate, cyanocrylate, anaerobics, acrylic, phenolics, and/or polyimide.

The filler may be one or more of ceramic, glass, or metal. Examples of filler include silver, gold, copper, steel, ceramic, glass, stainless steel, brass, tungsten, titanium, aluminum, magnesium, vanadium, chromium, iron, nickel, zinc, or tin. When a metal filler is used, it has been found that with sufficiently high fill ratios, the cured filled polymer becomes electrically conductive. The conductivity may be used to provide a ground path for a transducer electrical circuit.

Overall stability of the acoustic wave switch 10 is achieved by selecting a filled polymer 30 that has an operating temperature range equal to or better than the operating range of the substrate 14. Chemical resistance of the filled polymer 30 depends on the formulation of the filled polymer 30 itself. Accordingly, a particular filled polymer 30 may be chosen based on the desired chemical resistance for a particular application.

Figure 4 illustrates a cross-sectional view of the substrate 14 through line 4-4 of Figure 3, according to an embodiment of the present invention. The thickness $h_m$ of the filled polymer 30 is determined using the following equation:

$$\frac{2a}{bm}\sqrt{\frac{hm}{2bs}} \leq \frac{1}{n}$$

where $h_m = b_m - b_s$;

a is the radius of the mesa 16 defined by the filled polymer 30;

$h_m$ is the thickness of the filled polymer 30;

$b_s$ is the thickness of the substrate 14; and

$b_m$ is the thickness of substrate 14 + the filled polymer 30

n is the fundamental or overtone mode (e.g., 1 = fundamental, 3 is 3$^{rd}$ overtone)

The thickness $h_m$ may be altered to accommodate differences in density between the filled polymer 30 and the substrate 14. Variations in thickness generally correlate to differences in density.

Figure 5 illustrates an isometric bottom view of the substrate 14 having the transducer positioned 22 on the filled polymer 30 defining the mesa 16, according to an embodiment of the present invention. The transducer 22 is placed directly into or onto the uncured filled polymer 30. Once the filled polymer 30 is dispensed or applied into or onto the substrate 14, the transducer 22 is placed in the center of the filled polymer 30. For example, the transducer 22 may be positioned along a diameter of the filled polymer 30 and centered about the central axis of the filled polymer 30. Pressure is then applied to the transducer 22. The applied pressure is sufficient to overcome the viscosity of the filled polymer 30 and squeeze the filled polymer 30 from beneath the transducer 22 until only a thin layer of filled polymer 30 remains beneath the transducer 22. After such placement and positioning of the transducer 22, the assembly that includes the substrate 14, the filled polymer 30, and the transducer 22 is cured.

During the curing process, the filled polymer 30 that defines the mesa 16 bonds to the substrate 14. The filled polymer 30 may be cured using a variety of methods, such as through a chemical reaction when two parts are mixed or an activator contacts the filled polymer, visible light, ultraviolet light, heat, moisture, or the like.

Thus, embodiments of the present invention provide a method of forming an acoustic wave switch assembly that eliminates the additional process steps of adhesive placement on the bottom of the transducer, and holding the transducer in place before and during curing. Because the transducer 22 adheres to the filled polymer 30, the transducer 22 is secured in position before and during the curing process.

Embodiments of the present invention provide a number of advantages. It has been found that the filled polymer 30, such as described above, remains stable over the operative temperature range of the substrate 14. Additionally, the filled polymer 30 resists chemicals present in a typical operating environment.

The filled polymer 30 defines the mesa 16 and the resonant cavity 12 that is defined by the volume from the mesa 16 to the touch surface 18 on the opposite side of the substrate 14. The filled polymer 30 may be dispensed or applied onto the substrate 14 through a variety of techniques, such as, for example, silk screening, stencil printing, ink jet deposition, decaling, and the like.

The resulting acoustic wave switch 10 may be used as a touch sensitive device, liquid or ice sensing device, device for monitoring fatigue-cracking in structural members, and the like.

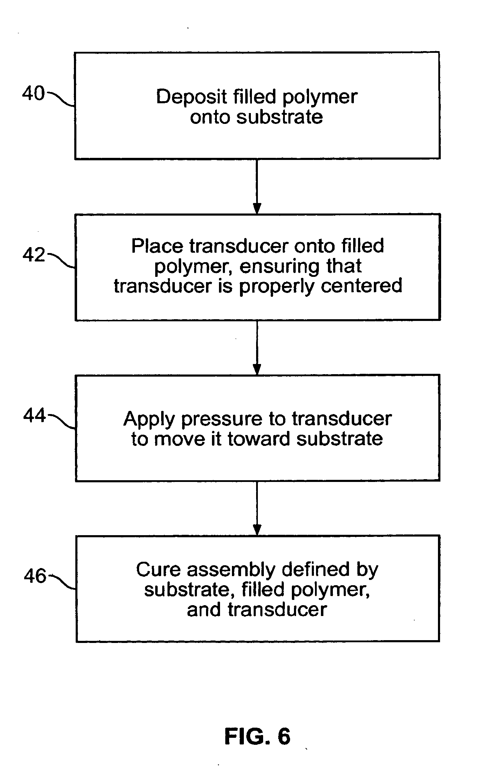

Figure 6 illustrates a flow chart of a method of fabricating a resonant cavity of an acoustic wave switch, according to an embodiment of the present invention. At 40, filled polymer material is deposited or applied onto the substrate, thereby defining a mesa area. A transducer is placed onto the filled polymer at 42. In this step, the transducer is properly centered with respect to the filled polymer. At 44, pressure is applied to the transducer, moving it toward the substrate, and squeezing filled polymer material out from underneath the transducer. At 46, the resulting assembly is cured to bond the substrate to the filled polymer, and the filled polymer to the transducer.

Unlike prior systems and methods, embodiments of the present invention provide a system and method of forming an acoustic wave switch that includes using a filled polymer, having adhesive qualities. Once the filled polymer is applied onto the substrate, the transducer is placed directly onto or into the uncured filled polymer. After the transducer is properly located in the center of the filled polymer, pressure is applied to the transducer toward the substrate. After the transducer is properly placed onto or into the filled polymer, the assembly is cured, thereby securely fastening the components together.

While various spatial and directional terms, such as top, bottom, lower, mid, lateral, horizontal, vertical, front and the like may used to describe embodiments of the present invention, it is understood that such terms are merely used with respect to the orientations shown in the drawings. The orientations may be inverted, rotated, or otherwise changed, such that an upper portion is a lower portion, and vice versa, horizontal becomes vertical, and the like.

Variations and modifications of the foregoing are within the scope of the present invention. It is understood that the invention disclosed and defined herein extends to all alternative combinations of two or more of the individual features mentioned or evident from the text and/or drawings. All of these different combinations constitute various alternative aspects of the present invention. The embodiments described herein explain the best modes known for practicing the invention and will enable others skilled in the art to utilize the invention. The claims are to be construed to include alternative embodiments to the extent permitted by the prior art.

Various features of the invention are set forth in the following claims.

## Claims

1. An acoustic wave switch assembly (10) comprising:

   a substrate (14) having first and second surfaces, wherein the first surface is opposite the second surface;
   a filled polymer (30) positioned on the first surface; and
   a transducer (22) secured on said filled polymer, wherein a resonant cavity (12) is defined by said filled polymer through said substrate from the first to second surfaces.

2. The acoustic wave switch assembly of claim 1, wherein said filled polymer comprises a base polymer and a filler.

3. The acoustic wave switch assembly of claim 2, wherein said base polymer comprises one or more of epoxy, urethane, polyurethane, methacrylate, cyanocrylate, anaerobics, acrylic, phenolics, and/or polyimide.

4. The acoustic wave switch assembly of claim 2, wherein said filler comprises a powder including one or more of silver, gold, copper, steel, ceramic, glass, stainless steel, brass, tungsten, titanium, aluminum, magnesium, vanadium, chromium, iron, nickel, zinc, and/or tin.

5. The acoustic wave switch assembly of claim 1, wherein said transducer is aligned along a diameter of said filled polymer.

6. A method of forming an acoustic wave switch assembly (10), the method comprising:

applying (40) an uncured filled polymer (30) on a first surface of a substrate (14);
positioning (42) a transducer (22) on the uncured filled polymer; and
curing (46) the uncured filled polymer, wherein said curing secures the filled polymer, the substrate, and the transducer together to form the acoustic wave switch assembly.

7. The method of claim 6, wherein said applying defines a resonant cavity (12) from said uncured filled polymer to a second surface of the substrate that is opposite the first surface.

8. The method of claim 6, comprising forming the uncured filled polymer with a base polymer and filler.

9. The method of claim 6, wherein said positioning comprises aligning the transducer in the center of the uncured filled polymer.

10. The method of claim 6, wherein said positioning comprises urging (44) the transducer into the uncured filled polymer such that at least a portion of the uncured filled polymer is squeezed out from underneath the transducer and adheres to sides of the transducer.

11. The method of claim 6, wherein said applying comprises silk screening the uncured filled polymer on the substrate.

12. A method of forming an acoustic wave switch assembly (10), the method comprising:

forming an uncured filled polymer (30) with a base polymer and filler;
depositing (40) the uncured filled polymer on a first surface of a substrate (14), wherein said depositing defines a resonant cavity (12) from said uncured filled polymer to a second surface of the substrate that is opposite the first surface;
positioning (42) a transducer (22) on the uncured filled polymer, wherein said positioning comprises aligning the transducer in the center of the uncured filled polymer;
urging (44) the transducer into the uncured filled polymer such that at least a portion of the uncured filled polymer is squeezed out from underneath the transducer and adheres to sides of the transducer; and
curing (46) the uncured filled polymer, wherein said curing secures the filled polymer, the substrate, and the transducer together to form the acoustic wave switch assembly.

13. The method of claim 6 or claim 12, wherein the base polymer comprises one or more of epoxy, urethane, polyurethane, methacrylate, cyanocrylate, anaerobics, acrylic, phenolics, and/or polyimide.

14. The method of claim 6 or claim 12, wherein the filler comprises a powder including one or more of silver, gold, copper, steel, ceramic, glass, stainless steel, brass, tungsten, titanium, aluminum, magnesium, vanadium, chromium, iron, nickel, zinc, and/or tin.

**Patentansprüche**

1. Akustikwellenschalteranordnung (10), die aufweist:

ein Substrat (14), das eine erste Seite und eine zweite Seite aufweist, wobei sich die erste Seite gegenüber der zweiten Seite befindet;
ein gefülltes Polymer (30), das an der ersten Seite angeordnet ist;
einen Transducer (22), der an dem gefüllten Polymer befestigt ist,
wobei über das gefüllte Polymer durch das Substrat von der ersten zur zweiten Seite ein Resonanzraum (12) festgelegt wird.

2. Akustikwellenschalteranordnung nach Anspruch 1, wobei das gefüllte Polymer ein Basispolymer und einen Füllstoff umfasst.

3. Akustikwellenschalteranordnung nach Anspruch 2, wobei das Basispolymer einen oder mehrere der folgenden Stoffe aufweist:

Epoxyverbindungen, Urethane, Polyurethane, Methacrylate, Cyanoacrylate, Anaerobe, Acrylverbindungen, Phenole und/oder Polyimide.

4. Akustikwellenschalteranordnung nach Anspruch 2, wobei der Füllstoff ein Pulver aufweist, das einen oder mehrere der folgenden Stoffe aufweist: Silber, Gold, Kupfer, Stahl, Keramik, Glas, Edelstahl, Messing, Wolfram, Titan, Aluminium, Magnesium, Vanadium, Chrom, Eisen, Nickel, Zink und/oder Zinn.

5. Akustikwellenschalteranordnung nach Anspruch 1, wobei der Transducer entlang eines Durchmessers des gefüllten Polymers orientiert ist.

6. Verfahren zur Bildung einer Akustikwellenschalteranordnung (10), wobei das Verfahren umfasst:

Aufbringen (40) eines ungehärteten gefüllten Polymers (30) auf eine erste Seite eines Substrats (14);
Positionieren (42) eines Transducers (22) auf dem ungehärteten gefüllten Polymer; und
Härten (46) des ungehärteten gefüllten Polymers, wobei durch das Härten das gefüllte Polymer, das Substrat und der Transducer zur Ausbildung der Akustikwellenschalteranordnung aneinander befestigt werden.

7. Verfahren nach Anspruch 6, worin durch das Auftragen ein Resonanzraum (12) von dem gefüllten Polymer zu einer zweiten Seite des Substrats definiert wird, die sich gegenüber der ersten Seite befindet.

8. Verfahren nach Anspruch 6, das umfasst, das ungehärtete gefüllte Polymer aus eine asispolymer und einem Füllstoff zu bilden.

9. Verfahren nach Anspruch 6, worin das Positionieren umfasst, den Transducer im Zentrum des ungehärteten gefüllten Polymers anzuordnen.

10. Verfahren nach Anspruch 6, worin das Positionieren ein Drücken (44) des Transducers in das ungehärtete gefüllte Polymer umfasst, sodass zumindest ein Teil des ungehärteten gefüllten Polymers unter dem Transducer herausgedrückt wird und an den Seiten des Transducers anhaftet.

11. Verfahren nach Anspruch 6, worin das Aufbringen ein Aufbringen des ungehärteten gefüllten Polymers auf das Substrat mittels Siebdruck umfasst.

12. Verfahren zur Bildung einer Akustikwellenschalteranordnung (10), wobei das Verfahren umfasst:

Bilden eines ungehärteten gefüllten Polymers (30) mit einem Basispolymer und einem Füllstoff;
Aufbringen (40) des ungehärteten gefüllten Polymers auf eine erste Seite eines Substrats (14);
wobei durch das Aufbringen ein Resonanzrau (12) von dem ungehärteten gefüllten Polymer zu einer zweiten Seite des Substrats definiert wird, die sich gegenüber der ersten Seite befindet;
Positionieren (42) eines Transducers (22) auf dem ungehärteten gefüllten Polymer, wobei das Positionieren umfasst, den Transducer im Zentru des ungehärteten gefüllten Polymers anzuordnen;
Drücken (44) des Transducers in das ungehärtete gefüllte Polymer, sodass zumindest ein Teil des ungehärteten gefüllten Polymers unter dem Transducer herausgedrückt wird und an den Seiten des Transducers anhaftet; und
Härten (46) des ungehärteten gefüllten Polymers, wobei durch das Härten das gefüllte Polymer, das Substrat und der Transducer zur Ausbildung der Akustikwellenschalteranordnung aneinander befestigt werden.

13. Verfahren nach Anspruch 6 oder Anspruch 12, worin das Basispolymer einen oder mehrere der folgenden Stoffe aufweist:

Epoxyverbindungen, Urethane, Polyurethane, Methacrylate, Cyanoacrylate, Anaerobe, Acrylverbindungen, Phenole und/oder Polyimide.

14. Verfahren nach Anspruch 6 oder Anspruch 12, worin der Füllstoff ein Pulver aufweist, das eine oder mehrere der folgenden Stoffe aufweist: Silber, Gold, Kupfer, Stahl, Keramik, Glas, Edelstahl, Messing, Wolfram, Titan, Aluminium, Magnesium, Vanadium, Chrom, Eisen, Nickel, Zink und/oder Zinn.

## Revendications

1. Ensemble commutateur à onde acoustique (10), comprenant :

un substrat (14) ayant des première et seconde surfaces, où la première surface est opposée à la seconde surface ;
un polymère chargé (30) positionné sur la première surface ; et
un transducteur (22) fixé sur ledit polymère chargé, où une cavité de résonnance (12) est définie par ledit polymère chargé à travers ledit substrat de la première à la deuxième surface.

2. Ensemble commutateur à onde acoustique selon la revendication 1, dans lequel ledit polymère chargé comprend un polymère de base et une charge.

3. Ensemble commutateur à onde acoustique selon la revendication 2, dans lequel ledit polymère de base comprend un ou plusieurs de époxy, uréthane, polyuréthane, méthacrylate, cyanoacrylate, anaérobies, acrylique, phénoliques et/ou poly-imide.

4. Ensemble commutateur à onde acoustique selon la revendication 2, dans lequel ladite charge comprend une poudre incluant un ou plusieurs d'argent, or, cuivre, acier, céramique, verre, acier inoxydable, laiton, tungstène, titane, aluminium, magnésium, vanadium, chrome, fer, nickel, zinc et/ou étain.

5. Ensemble commutateur à onde acoustique selon la revendication 1, dans lequel ledit transducteur est aligné le long d'un diamètre dudit polymère chargé.

6. Procédé pour former un ensemble commutateur à onde acoustique (10), le procédé comprenant :

appliquer (40) un polymère chargé non durci (30) sur une première surface d'un substrat (14) ;
positionner (42) un transducteur (22) sur le polymère chargé non durci ; et
durcir (46) le polymère chargé non durci, où ledit durcissement fixe le polymère chargé, le substrat et le transducteur ensemble pour former l'ensemble commutateur à onde acoustique.

7. Procédé selon la revendication 6, dans lequel ladite application définit une cavité de résonnance (12) dudit polymère chargé non durci à une seconde surface du substrat qui est opposée à la première surface.

8. Procédé selon la revendication 6, comprenant la formation du polymère chargé non durci avec un polymère de base et une charge.

9. Procédé selon la revendication 6, dans lequel ledit positionnement comprend l'alignement du transducteur dans le centre du polymère chargé non durci.

10. Procédé selon la revendication 6, dans lequel ledit positionnement comprend la sollicitation (44) du transducteur dans le polymère chargé non durci de sorte qu'au moins une portion du polymère chargé non durci ressort depuis en dessous du transducteur et adhère aux côtés du transducteur.

11. Procédé selon la revendication 6, dans lequel ladite application comprend la sérigraphie du polymère chargé non durci sur le substrat.

12. Procédé pour former un ensemble commutateur à onde acoustique (10), le procédé comprenant :

former un polymère chargé non durci (30) avec un polymère de base et une charge ;
déposer (40) le polymère chargé non durci sur une première surface d'un substrat (14),

où ledit dépôt définit une cavité de résonnance (12) du polymère chargé non durci à une seconde surface du substrat qui est opposée à la première surface ;

positionner (42) un transducteur (22) sur le polymère chargé non durci, où ledit positionnement comprend l'alignement du transducteur dans le centre du polymère chargé non durci solliciter (44) le transducteur dans le polymère chargé non durci de sorte qu'au moins une portion du polymère chargé non durci ressorte depuis en dessous du transducteur et adhère aux côtés du transducteur ; et
durcir (46) le polymère chargé non durci, où ledit durcissement fixe le polymère chargé, le substrat et le transducteur ensemble pour former l'ensemble commutateur à onde acoustique.

13. Procédé selon la revendication 6 ou la revendication 12, dans lequel le polymère de base comprend un ou plusieurs d'époxy, uréthane, polyuréthane, méthacrylate, cyanoacrylate, anaérobies, acryliques, phénoliques et/ou poly-imide.

14. Procédé selon la revendication 6 ou la revendication 12, dans lequel la charge comprend un poudre incluant un ou plusieurs d'argent, or, cuivre, acier, céramique, verre, acier inoxydable, laiton, tungstène, titane, aluminium, magnésium, vanadium, chrome, fer, nickel, zinc et/ou étain.

**FIG. 1**

FIG. 2

FIG. 3

FIG. 4

FIG. 5

40 — | Deposit filled polymer onto substrate |

42 — | Place transducer onto filled polymer, ensuring that transducer is properly centered |

44 — | Apply pressure to transducer to move it toward substrate |

46 — | Cure assembly defined by substrate, filled polymer, and transducer |

**FIG. 6**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7106310 B
- US 20020126103 A1
- US 7265746 B
- US 7265 A